# EUROPÄISCHE PATENTSCHRIFT

(11) **EP 3 791 006 B1**
(45) Veröffentlichungstag und Bekanntmachung des Hinweises auf die Patenterteilung: **29.06.2022**
(21) Anmeldenummer: 19724763.8
(22) Anmeldetag: 08.05.2019
(51) Int. Cl.: H01L 21/67, C23C 16/46, C23C 16/54, C23C 14/34, C23C 14/50, C23C 14/54, C23C 14/56

(54) **VORRICHTUNG ZUM BESCHICHTEN EINES BANDFÖRMIGEN SUBSTRATES**
APPARATUS FOR COATING A STRIP-SHAPED SUBSTRATE
DISPOSITIF DE REVÊTEMENT D'UN SUBSTRAT EN FORME DE BANDE

(30) Priorität: 09.05.2018 DE 102018111105
(43) Veröffentlichungstag der Anmeldung: 17.03.2021
(73) Patentinhaber: Fraunhofer-Gesellschaft zur Förderung der angewandten Forschung e.V., 80686 München (DE)
(72) Erfinder: FAHLAND, Matthias, 01257 Dresden (DE); FAHLTEICH, John, 01279 Dresden (DE); PRAGER, Nicole, 01723 Grumbach (DE); MEYER, Uwe, 01477 Arnsdorf (DE); VOGT, Tobias, 01277 Dresden (DE)
(86) Internationale Anmeldenummer: PCT/EP2019/061877
(87) Internationale Veröffentlichungsnummer: WO 2019/215264

(56) Entgegenhaltungen:
- EP-A1- 2 818 576
- WO-A1-2018/082792
- JP-B2- 5 741 522
- US-A1- 2010 291 308
- US-A1- 2011 281 029

## Beschreibung

Die Erfindung betrifft eine Vorrichtung zum Beschichten von bandförmigen Substraten innerhalb einer Vakuumkammer, wobei das bandförmige Substrat während des Beschichtungsvorgangs gekühlt wird.

Beim Beschichten von bandförmigen Substraten im Vakuum kann es durch den Energieeintrag, der während des Beschichtens auf das bandförmige Substrat einwirkt, sehr leicht zu einer irreversiblen Verformung des Substrates kommen. Eine solche Verformung, infolge einer Überhitzung des bandförmigen Substrates, kann beispielsweise durch eine chemische Veränderung des Substratmaterials oder auch durch eine Faltenbildung oder durch plastisches Überstrecken des Substrates verursacht werden. Eine effektive Kühlung des bandförmigen Substrates kann dazu beitragen, die benannten Probleme zu lösen bzw. zu verhindern.

Üblicherweise wird ein zu beschichtendes bandförmiges Substrat von einer Vorratsrolle kontinuierlich abgerollt und abschließend auf eine andere Rolle, die sogenannte Aufnahmerolle, kontinuierlich wieder aufgewickelt. Das zu beschichtende bandförmige Substrat durchläuft während dieses Wickelvorgangs einen oder mehrere Bereiche, in denen eine Beschichtung stattfindet. Diese Beschichtung kann beispielsweise durch Kathodenzerstäuben oder einen Verdampfungsprozess realisiert werden.

Eine wichtige Gruppe von bandförmigen Substraten, die im Vakuum beschichtet werden, sind Kunststofffolien. Üblicherweise werden Kunststofffolien während eines Beschichtungsvorgangs über mindestens eine Kühlwalze geführt. Dabei werden sie durch zwei wesentliche Mechanismen gekühlt: Zum einen durch einen direkten Kontakt zwischen der Kunststofffolie und der Kühlwalze und zum anderen durch einen Wärmetransfer über Wassermoleküle, die aus der Kunststofffolie ausdampfen und dann zwischen der Kunststofffolie und der Kühlwalze eingeschlossen sind.

Es ist bekannt, dass bei der überwiegenden Anzahl der Beschichtungsprozesse von Kunststofffolien der zweite der beiden genannten Kühlmechanismen dominiert und erst durch diesen Kühlmechanismus eine für die Durchführbarkeit des Prozesses ausreichende Kühlung gewährleistet ist. Problematisch ist das Beschichten von Kunststofffolien deshalb insbesondere dann, wenn die Kunststofffolie nach einem Beschichtungsvorgang noch nachfolgende Beschichtungsstationen durchläuft, wie zum Beispiel in JP 5741522 B2 beschrieben, aber dann nicht mehr genügend Wassermoleküle in der Kunststofffolie vorhanden sind, die ausdampfen und einen Wärmekontakt zwischen Kunststofffolie und Kühleinrichtung herstellen können. Die gleiche Problematik besteht bei wasserarmen Kunststofffolien, wie z.B. aus Cycloolefin-Polymer (COP), schon bei einem ersten Beschichtungsvorgang, wie auch bei bandförmigen Substraten aus Metall oder Glas.

Aus dem Stand der Technik sind verschiedene Ansätze bekannt, um dieses technische Problem zu lösen. In US 5 076 203 A wird beispielsweise ein Gas direkt an der Stelle eingelassen, an der die Kunststofffolie die Kühlwalze berührt.

Eine ähnliche Lösung ist in DE 10 2013 212 395 A1 beschrieben. Hier wird zunächst Wasserdampf auf die Kühlwalze aufgesprüht, wobei die Kühlwalze soweit gekühlt wird, dass der Wasserdampf in den festen Aggregatzustand übergeht und somit eine Eisschicht zwischen Kühlwalze und einer zu beschichtenden Kunststofffolie ausgebildet wird. Während des Beschichtungsvorgangs geht diese Eisschicht aufgrund des Wärmeeintrags durch die Beschichtungseinrichtung in den flüssigen bzw. gasförmigen Zustand über und gewährleistet dann einen Wärmeübergang zwischen Kühlwalze und Kunststofffolie. Nachteilig wirkt sich bei den beiden zuvor genannten Lösungen aus, dass das in die Vakuumkammer eingelassene Gas bzw. der eingelassene Wasserdampf die Prozessatmosphäre innerhalb der Vakuumkammer negativ beeinflussen kann. Weiterer relevanter Stand der Technik ist in dem Gebrauchsmuster DE202016100186U1 offenbart.

In DE 10 2012 013 726 A1 wird vorgeschlagen, ein Fluid zum Kühlen eines bandförmigen Substrates durch die konvexe Wandung einer Kühleinrichtung hindurch zwischen einem bandförmigen Substrat und der Kühleinrichtung einzulassen. In US 2010/0291308 A1 wird zusätzlich vorgeschlagen, die Oberfläche der Kühleinrichtung mit einem Elastomer zu beschichten, um die Wärmeleitung zwischen Substrat und Kühleinrichtung zu verbessern. Derartige Vorrichtungen sind jedoch technisch sehr aufwändig.

Der Erfindung liegt daher das technische Problem zugrunde, eine Vorrichtung zum Beschichten eines bandförmigen Substrates zu schaffen, mittels der die Nachteile aus dem Stand der Technik überwunden werden können. Insbesondere sollen mit der erfindungsgemäßen Vorrichtung ein verbesserter Kühleffekt und eine geringere Tendenz zur Faltenbildung während des Beschichtens erzielbar sein. Des Weiteren soll die erfindungsgemäße Vorrichtung das Beschichten und Kühlen von bandförmigen Substraten aus Kunststoff, Metall und Glas gewährleisten und auch das effektive Kühlen eines bandförmigen Substrates ermöglichen, wenn dieses mehrfach nacheinander beschichtet wird.

Die Lösung des technischen Problems ergibt sich durch Gegenstände mit den Merkmalen des Patentanspruchs 1. Weitere vorteilhafte Ausgestaltungen der Erfindung ergeben sich aus den abhängigen Ansprüchen.

Eine erfindungsgemäße Vorrichtung zum Beschichten eines bandförmigen Substrates umfasst mindestens eine Beschichtungseinrichtung und mindestens eine Kühleinrichtung. Dabei weist die mindestens eine Kühleinrichtung zumindest einen Oberflächenbereich auf, welchen das bandförmige Substrat zum Zeitpunkt des Beschichtens mittels der mindestens einen Beschichtungseinrichtung zumindest teilweise berührt. Eine solche Kühlleinrichtung kann beispielsweise als Kühltrommel, als Kühlwalze oder als Kühlband ausgebildet sein. Erfindungsgemäß besteht eine Randschicht der Kühleinrichtung zumindest innerhalb des Oberflächenbereichs, welchen das bandförmige Substrat zum Zeitpunkt des Beschichtens mittels der mindestens einen Beschichtungseinrichtung zumindest teilweise berührt, aus einem Kunststoff. Der Kunststoff weist dabei eine säulenförmige Struktur auf, wobei die Säulen der säulenförmigen Struktur mit einer Säulenhöhe im Bereich von 50 µm bis 500 µm und mit einem Säulenquerschnitt im Bereich von 300 µm² bis 10.000 µm² ausgebildet werden. Dabei sind die Säulen der säulenförmigen Struktur während des Kontaktes mit dem zu beschichtenden Substrat quer zur Oberfläche des zu beschichtenden Substrates ausgerichtet.

Bei einer derart ausgebildeten Oberflächenstruktur der Kühleinrichtung wirken die Säulen der säulenförmigen Struktur als eine Vielzahl von mikroskopischen Haftelementen, die anziehende Kräfte, wie beispielsweise Van-der-Waals-Kräfte erzeugen, ähnlich, wie die Vielzahl feiner Härchen an der Unterseite der Füße bei Geckos. Die anziehenden Kräfte resultieren aus elektrostatischen Interaktionen der säulenförmigen mikroskopischen Haftelemente. Bei einer erfindungsgemäßen Vorrichtung bewirken die durch die Vielzahl der Säulen der säulenförmigen Struktur hervorgerufenen anziehenden Kräfte, dass das zu beschichtende Substrat an die Oberfläche der Kühleinrichtung gezogen wird. Einerseits wird dadurch ein besserer Kontakt zur Kühleinrichtung hergestellt, was die Kühlwirkung erhöht, andererseits wird das Schlagen von Falten des zu beschichtenden bandförmigen Substrates verringert, insbesondere bei bandförmigen Substraten, die als Kunststofffolie ausgebildet sind. Weil bei einer erfindungsgemäßen Vorrichtung eine, gegenüber dem Stand der Technik, erhöhte Anpresskraft zwischen einem zu beschichtenden bandförmigen Substrat und einer Kühleinrichtung erzielbar ist und deshalb kein Wärmeleitmedium zwischen Substrat und Kühleinrichtung erforderlich ist, ist eine erfindungsgemäße Vorrichtung nicht nur zum Beschichten von Kunststofffolien sondern auch zum Beschichten von Metallfolien oder Glasfolien geeignet, als auch für Beschichtungsaufgaben, bei denen das bandförmige Substrat an mehreren Beschichtungsstationen nacheinander beschichtet wird.

Die Randschicht einer Kühleinrichtung, welche aus Kunststoff besteht und eine zuvor beschriebene säulenförmige Struktur aufweist, kann beispielsweise als Kunststofffolie ausgebildet sein, die an der Oberfläche eines Basiselements der Kühleinrichtung befestigt ist. Hierfür sind zum Beispiel Silikonfolien und Polyimidfolien, welche die zuvor beschriebene säulenförmige Struktur aufweisen, sehr gut geeignet. Für eine erfindungsgemäße Vorrichtung kann beispielsweise eine Silikonfolie verwendet werden, die unter dem Markennamen Nanoplast^{®} vertrieben wird. Das Basiselement einer Kühleinrichtung kann beispielsweise als Kühlwalze, Kühltrommel oder Kühlband ausgebildet sein.

Bei einer Ausführungsform ist die Kunststofffolie mit der säulenförmigen Struktur zunächst auf einer Aluminiumfolie aufgeklebt und der Verbund aus Aluminiumfolie und Kunststofffolie an einem Basiselement der Kühleinrichtung befestigt. Das hat den Vorteil, dass sich ein Verbund aus Aluminiumfolie und Kunststofffolie einfacher vom Basiselement einer Kühleinrichtung entfernen lässt als eine separate Kunststofffolie, welche beispielsweise beim Entfernen vom Basiselement der Kühleinrichtung zerreißen kann. Ein Verbund aus Aluminiumfolie und Kunststofffolie kann hingegen für spätere Anwendungsfälle wiederverwendet und erneut am Basiselement einer Kühleinrichtung befestigt werden. Ein solcher Verbund aus Aluminiumfolie und Kunststofffolie kann beispielsweise auf ein Basiselement einer Kühleinrichtung aufgeklebt werden.

Die Erfindung wird nachfolgend an Ausführungsbeispielen näher beschrieben. Die Fig. zeigen:
- Fig. 1: eine schematische Schnittdarstellung einer erfindungsgemäßen Vorrichtung;
- Fig. 2: eine schematische Schnittdarstellung einer alternativen erfindungsgemäßen Vorrichtung.

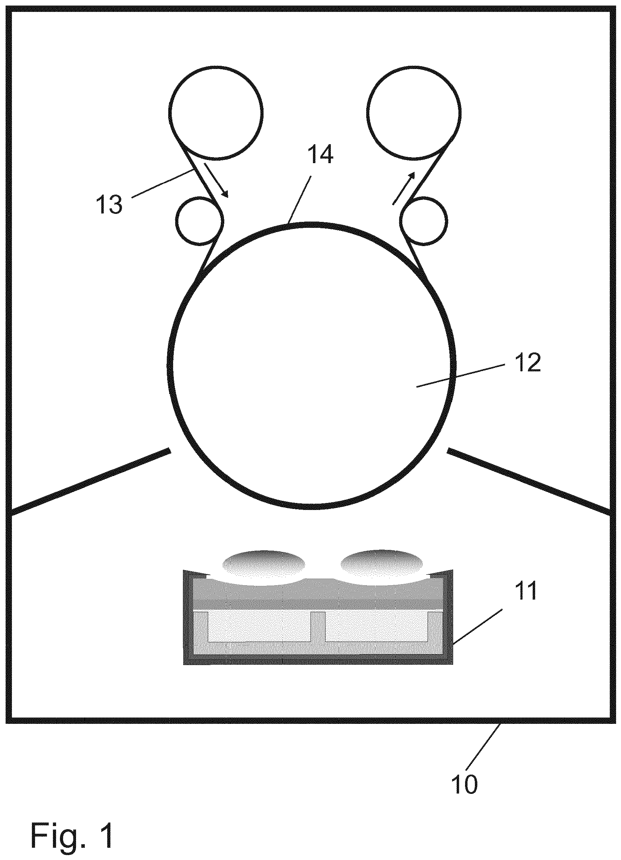

In Fig. 1 ist eine erfindungsgemäße Vorrichtung schematisch dargestellt. Innerhalb einer Vakuumkammer 10 sind eine als Sputtermagnetron ausgebildete Beschichtungseinrichtung 11 und eine als Kühlwalze ausgebildete Kühleinrichtung 12 angeordnet. Ein als Kunststofffolie ausgebildetes bandförmiges Substrat 13 umschlingt die Kühleinrichtung 12 zum Zeitpunkt des Beschichtens mittels der Beschichtungseinrichtung 11 teilweise, wodurch das bandförmige Substrat 13 die Kühleinrichtung 12 in einem Oberflächenbereich während des Beschichtungsvorgangs zumindest teilweise berührt. Die Pfeile in der Fig. 1 geben die Bewegungsrichtung des bandförmigen Substrates 13 an.

Ein Verbund 14 bildet eine äußere Randschicht der Kühleinrichtung 12 und besteht aus einer Aluminiumfolie, auf welche eine unter dem Markennamen Nanoplast^{®} vertriebene Silikonfolie aufgeklebt wurde. Die Silikonfolie weist eine säulenförmige Struktur auf, bei der auf einem Quadratzentimeter etwa 30.000 als mikroskopische Haftelemente wirkende Säulen ausgebildet sind, wobei sich die Säulen entlang der Dickenausdehnung der Silikonfolie erstrecken. Der Verbund 14 wiederum wurde an der Aluminiumfolienseite auf dem walzenförmigen Basiselement der Kühleinrichtung 12 aufgeklebt. Die als mikroskopische Haftelemente fungierenden Säulen der Silikonfolie bewirken eine elektrostatische Interaktion, welche das bandförmige Substrat 13 an die Kühleinrichtung 12 anzieht. Auf diese Weise wird eine verbesserte Kühlung des bandförmigen Substrates 13 erzielt und das Schlagen von Falten des bandförmigen Substrates 13 während des Beschichtens mittels der Beschichtungseinrichtung 11 verringert.

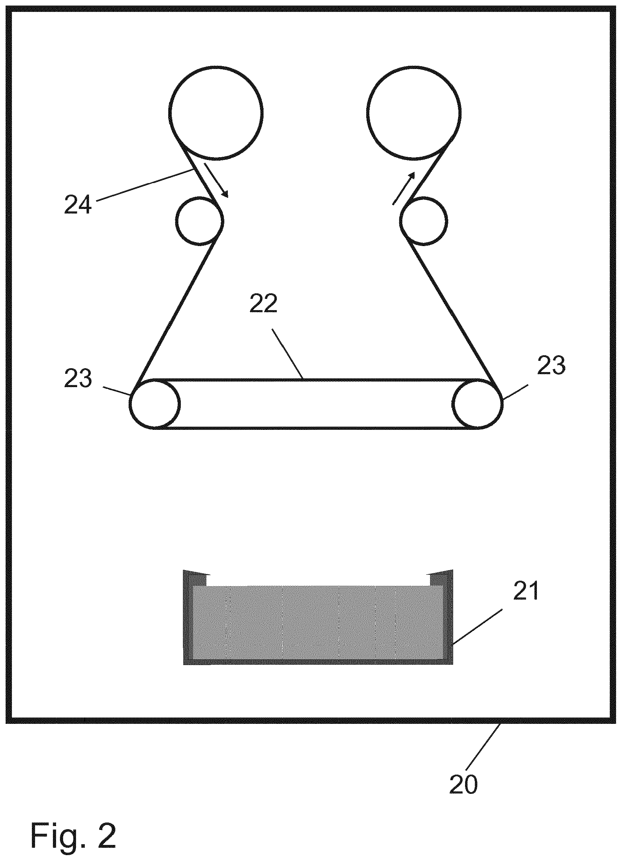

Eine alternative erfindungsgemäße Vorrichtung ist in Fig. 2 schematisch dargestellt. Innerhalb einer Vakuumkammer 20 sind eine als thermischer Verdampfer ausgebildete Beschichtungseinrichtung 21 und eine als Kühlband ausgebildete Kühleinrichtung 22 angeordnet. Das Kühlband besteht aus Aluminium und wird über zwei Umlenkrollen 23 geführt. An der Außenseite des Kühlbandes ist eine Polyimidfolie aufgeklebt, welche eine säulenförmige Struktur aufweist. Die säulenförmige Struktur wird von Polyimidsäulen gebildet, welche eine Länge von etwa 200 µm aufweisen. Die Polyimidsäulen erstrecken sich entlang der Dickenausdehnung der Polyimidfolie und sind mit einer Anzahl von mindestens 20.000 Stück pro Quadratzentimeter ausgebildet.

Ein mittels der Beschichtungseinrichtung 21 zu beschichtendes bandförmiges Substrat 24 umschlingt die Kühleinrichtung 22 während des Beschichtungsvorgangs teilweise und bildet auf diese Weise einen mechanischen Kontakt zur Kühleinrichtung 22 aus. Die als mikroskopische Haftelemente fungierenden Säulen der auf dem Kühlband aufgeklebten Polyimidfolie bewirken eine elektrostatische Interaktion, welche das bandförmige Substrat 24 an die Kühleinrichtung 22 anzieht. Auf diese Weise wird eine verbesserte Kühlung des bandförmigen Substrates 24 erzielt und das Schlagen von Falten des bandförmigen Substrates 24 während des Beschichtens mittels der Beschichtungseinrichtung 21 verringert.

## Patentansprüche

1. Vorrichtung zum Beschichten eines bandförmigen Substrates (13; 24) innerhalb einer Vakuumkammer, umfassend eine Beschichtungseinrichtung (11; 21) und eine Kühleinrichtung (12; 22) mit zumindest einem Oberflächenbereich, welchen das bandförmige Substrat (13; 24) zum Zeitpunkt des Beschichtens zumindest teilweise berührt, **dadurch gekennzeichnet, dass** eine Randschicht des Oberflächenbereichs der Kühleinrichtung (12; 22), aus einem Kunststoff besteht, welcher eine säulenförmige Struktur aufweist, wobei die Säulen der säulenförmigen Struktur mit einer Säulenhöhe im Bereich von 50 µm bis 500 µm und mit einem Säulenquerschnitt im Bereich von 300 µm² bis 10.000 µm² ausgebildet und die Säulen der säulenförmigen Struktur während des Kontaktes mit dem zu beschichtenden Substrat quer zur Oberfläche des zu beschichtenden Substrates ausgerichtet sind.

2. Vorrichtung nach Anspruch 1, **dadurch gekennzeichnet, dass** die Randschicht des Oberflächenbereichs der Kühleinrichtung (12; 22) aus Kunststoff als Kunststofffolie ausgebildet ist, welche an einem Basiselement der Kühleinrichtung (12; 22) befestigt ist.

3. Vorrichtung nach Anspruch 2, **dadurch gekennzeichnet, dass** die Kunststofffolie als Silikonfolie ausgebildet ist.

4. Vorrichtung nach Anspruch 2, **dadurch gekennzeichnet, dass** die Kunststofffolie als Polyimidfolie ausgebildet ist.

5. Vorrichtung nach Anspruch 2 bis 4, **dadurch gekennzeichnet, dass** die Kunststofffolie auf einer Aluminiumfolie aufgeklebt ist und dass der Verbund aus Aluminiumfolie und Kunststofffolie an einem Basiselement der Kühleinrichtung befestigt ist.

6. Vorrichtung nach einem der Ansprüche 2 bis 5, **dadurch gekennzeichnet, dass** das Basiselement der Kühleinrichtung (12) als Kühlwalze oder Kühltrommel ausgebildet ist.

7. Vorrichtung nach einem der Ansprüche 1 bis 5, **dadurch gekennzeichnet, dass** die Kühleinrichtung (22) ein Kühlband aufweist.

8. Vorrichtung nach einem der vorhergehenden Ansprüche, **dadurch gekennzeichnet, dass** das bandförmige Substrat als Kunststofffolie, als Metallfolie oder als Glasfolie ausgebildet ist.

## Claims

1. Apparatus for coating a strip substrate (13; 24) within a vacuum chamber, comprising a coating device (11; 21) and a cooling device (12; 22) having at least one surface region in at least partial contact with the strip substrate (13; 24) at the time of coating, **characterized in that** an edge layer of the surface region of the cooling device (12; 22) consists of a polymer having a column structure, wherein the columns of the column structure have a column height in the range from 50 µm to 500 µm and with a column cross section in the range from 300 µm² to 10 000 µm², and the columns of the column structure are aligned transverse to the surface of the substrate to be coated during the contact with the substrate to be coated.

2. Apparatus according to Claim 1, **characterized in that** the edge layer of the surface region of the cooling device (12; 22) is formed from polymer as a polymer film, secured on a base element of the cooling device (12; 22).

3. Apparatus according to Claim 2, **characterized in that** the polymer film takes the form of a silicone film.

4. Apparatus according to Claim 2, **characterized in that** the polymer film takes the form of a polyimide film.

5. Apparatus according to Claims 2 to 4, **characterized in that** the polymer film is bonded to an aluminium foil, and **in that** the composite composed of aluminium foil and polymer film is secured to a base element of the cooling device.

6. Apparatus according to any of Claims 2 to 5, **characterized in that** the base element of the cooling device (12) takes the form of a chill roll or chill drum.

7. Apparatus according to any of Claims 1 to 5, **characterized in that** the cooling device (22) has a cooling belt.

8. Apparatus according to any of the preceding claims, **characterized in that** the strip substrate takes the form of a polymer film, metal foil or glass film.

## Revendications

1. Dispositif destiné au revêtement d'un subjectile en forme de bande (13 ; 24) à l'intérieur d'une chambre à vide, comprenant un dispositif de revêtement (11 ; 21) et un dispositif de refroidissement (12 ; 22) présentant au moins une zone superficielle qui se trouve au moins partiellement en contact avec le subjectile en forme de bande (13 ; 24) au moment de l'enduction, **caractérisé en ce qu'**une couche superficielle de la zone superficielle du dispositif de refroidissement (12 ; 22) est constituée d'une matière plastique qui présente une structure colonnaire, les colonnes de la structure colonnaire étant configurées avec une hauteur de colonne dans la plage de 50 µm à 500 µm et avec une section transversale de colonne dans la plage de 300 µm² à 10 000 µm² et les colonnes de la structure colonnaire étant pendant le contact avec le subjectile à revêtir orientées transversalement par rapport à la surface du subjectile à revêtir.

2. Dispositif selon la revendication 1, **caractérisé en ce que** la couche superficielle de la zone superficielle du dispositif de refroidissement (12 ; 22) est à base de matière plastique, configurée en tant que film de matière plastique qui est fixé à un élément de base du dispositif de refroidissement (12 ; 22).

3. Dispositif selon la revendication 2, **caractérisé en ce que** le film de matière plastique est configuré en tant que film de silicone.

4. Dispositif selon la revendication 2, **caractérisé en ce que** le film de matière plastique est configuré en tant que film de polyimide.

5. Dispositif selon l'une quelconque des revendications 2 à 4, **caractérisé en ce que** le film de matière plastique est collé sur une feuille d'aluminium et **en ce que** le composite de feuille d'aluminium et film de matière plastique est fixé sur un élément de base du dispositif de refroidissement.

6. Dispositif selon l'une quelconque des revendications 2 à 5, **caractérisé en ce que** l'élément de base du dispositif de refroidissement (12) est configuré en tant que cylindre refroidisseur ou tambour refroidisseur.

7. Dispositif selon l'une quelconque des revendications 1 à 5, **caractérisé en ce que** le dispositif de refroidissement (22) comporte une bande de refroidissement.

8. Dispositif selon l'une quelconque des revendications précédentes, **caractérisé en ce que** le subjectile en forme de bande est configuré en tant que film de matière plastique, en tant que feuille métallique ou en tant que feuille de verre.
